Europäisches Patentamt

European Patent Office

Office européen des brevets

(11) Publication number: 0 374 740 A2

# EUROPEAN PATENT APPLICATION

(21) Application number: 89123168.0

(51) Int. Cl.⁵: **H01L 21/00**

(22) Date of filing: **14.12.89**

(30) Priority: **20.12.88 US 287173**
**20.12.88 US 287753**

(43) Date of publication of application:
**27.06.90 Bulletin 90/26**

(84) Designated Contracting States:
**DE FR GB IT NL**

(71) Applicant: **TEXAS INSTRUMENTS**
**INCORPORATED**
**13500 North Central Expressway**
**Dallas Texas 75265(US)**

(72) Inventor: **Ishii, Kaoru**
**3201 Cross Timbers**
**Garland Texas 75042(US)**
Inventor: **Wilkinson, Thomas F.**
**1617 McDonald Drive**
**Garland Texas 75041(US)**

(74) Representative: **Leiser, Gottfried, Dipl.-Ing. et**
**al**
**Patentanwälte Prinz, Leiser, Bunke & Partner**
**Manzingerweg 7**
**D-8000 München 60(DE)**

(54) Semiconductor wafer carrier design.

(57) A carrier-susceptor (40) for use in a continuous
chemical vapor deposition reactor system (10)
serves as a carrier, cover and heat susceptor for a
semiconductor wafer being processes through the
reactor system (10).

Fig. 1

## SEMICONDUCTOR WATER CARRIER DESIGN

### FIELD OF THE INVENTION

This invention relates to semiconductor wafer carriers and more particularly to carriers and carrier lid configurations for use in continuous chemical vapor deposition reactors.

### BACKGROUND OF THE INVENTION

A continuous chemical deposition reactor may be a stand-alone process system with a continuous semiconductor wafer flow. Basic subsystems in such a system may include a wafer handling, a reaction chamber, a gas flow system, a cooling system, and an electrical system.

The wafer handling system may include wafer loaders and unloaders, wafer carriers, and a track for moving a wafer through the reactor chambers.

The reactor chamber subsystem is the site for processing the semiconductor wafer. Each chamber may include a gas supply inlet, a chamber housing, heat lamps and exhaust.

The gas flow subsystem supplies the reactant gases to each chamber, and may include valves, flow controllers and an exhaust system.

The cooling subsystem assists in maintaining the process temperature and reduces the heat radiation to the surrounding components. Both air flow and water flow may be used in the cooling subsystem.

The electrical subsystem provides subsystem control and powers the reactor, and may include power supplies, motors, sensors, valves, and one or more computer/controller.

A basic reactor and process may be as follows. A semiconductor wafer is loaded onto a carrier which enters one end of the reactor through a port and is moved successively through the various chambers and out the other end of the reactor through another port. The reactor may not be physically closed, but has gas seals at each end and in between each chamber of the reactor. As an example, a reactor may include eight chambers in which the first chamber consists of a nitrogen seal, the second chamber is a preheat chamber, the next four chambers may be deposition chambers, then a cool-down chamber, and the last chamber is a nitrogen seal.

A typical gas supply system may supply gases for two different deposition processes which may be directed into any of the deposition chambers. Each chamber is effectively divided into two portions, a top portion and a bottom portion by the wafer carriers and spacers between each wafer carrier. The junctions between the chambers effectively isolate one chamber from the other by the flow of gases or the exhaust gases from the chambers.

### SUMMARY OF THE INVENTION

The invention relates to susceptor or wafer carriers and carrier lid configurations used in multi-chamber continuous chemical vapor deposition reactors. A semiconductor wafer is removed from a wafer cassette by a robotic arm and is placed in a carrier. The carrier may be one of several configurations to accommodate wafers of different diameters. Each carrier, which may be, for example, of graphite or graphite coated with silicon carbide, may hold one or more wafers, depending upon the diameter of the wafer. The wafer is placed so that it is face down in the reactor such that all processing of the wafer is done from the underside of the carrier, and a lid is placed over the up-side of the semiconductor wafer to prevent process or other gases from reacting that side, and to provide a uniform heat distribution to the semiconductor during processing.

The carrier lid serves as the susceptor or heat transfer media to deliver heat to the wafer during processing. In processing through a CCVD (continuous chemical vapor deposition) reactor. A semiconductor wafer is placed in a carrier and is moved successively through the various chambers and out the end of the reactor. The semiconductor wafer is placed inverted in the carrier so that the process surface of the semiconductor wafer is face down in the carrier, exposed to process gases through an opening in the under side of the carrier, and the carrier lid covers the up-side or back side of the semiconductor and serves as the susceptor for radiant heat from incandescent lamp heaters.

The carrier is optimized so that it may be used for one eight inch semiconductor wafer or two six inch semiconductor wafers. In prior systems, different reactors had to be used for different wafer sizes.

In one embodiment of the invention, the wafer is held in place by clips on the under side of the carrrier. In another embodiment of the invention, the wafer is placed in two slots or tracks formed on the under side of the carrier. In the two examples mentioned above, the carrier serves as the susceptor or heat transfer media to deliver heat to the wafer during processing.

A semiconductor wafer is placed in a carrier and is moved successively through the various chambers and out the end of the reactor. The semiconductor wafer is placed inverted on the carrier. The carrier is the susceptor for radiant heat from incandescent lamp heaters.

Each chamber has an associated heat lamp, gas inlets and outlets, a track on which the wafer carrier is moved, there being round grooves on two sides of the carrier that side on the tracks, and seals to prevent the gas from escaping to the environment out side the reactor, and to prevent exhaust gases from entering the process chambers, or reaction gases from entering the topside of the reactor chamber. The carrier is also used to block the movement of process gas to the reactor chamber area above the carrier.

Each chamber of the reactor is divided into two regions by the wafer carrier. These two regions are regions above the carrier and below the carrier. The process gas flows through the lower part of the reactor below the carrier and across the exposed semiconductor wafer face.

An inert gas may be directed through the upper region of the reactor to prevent the process gases from entering the upper region and to help provide the gas pressure differential needed to prevent exhaust gases from entering the process region of the reactor.

The junction between chambers effectively isolates one chamber from the other by the flow process gases or the exhaust of gas or gases from the chambers.

The technical advance represented by the invention as well as the objects thereof will become apparent from the following description of a preferred embodiment of the invention when considered in conjunction with the accompanying drawings, and the novel features set forth in the appended claims.

## BRIEF DESCRIPTIONS OF THE DRAWINGS

Figure 1 illustrates a typical CCVD reactor in which the present invention may be used;

Figure 2 illustrates a top loading semiconductor carrier of the prior art;

Figure 3 illustrates a bottom loading semiconductor carrier according to the present invention;

Figure 4 is a cross section of a part of Figure 3 showing the mounting lip of the bottom loading semiconductor carrier;

Figure 5 is another embodiment of a bottom loading semiconductor carrier;

Figure 6 is a partial cross-sectional view of the carrier of Figure 5,

Figure 7 illustrates another embodiment of a bottom loading semiconductor wafer carrier; and

Figure 8 is a partial cross-sectional view of the carrier of Figure 7.

Figure 9 illustrates a top loading semiconductor carrier an alternative embodiment of the present invention;

Figure 10 is a top view of the semiconductor carrier of; Figure 9 and

Figure 11 is a side view of the semiconductor carrier of Figure 9 and the lid in a raised position.

## DESCRIPTION OF A PREFERRED EMBODIMENT OF THE INVENTION

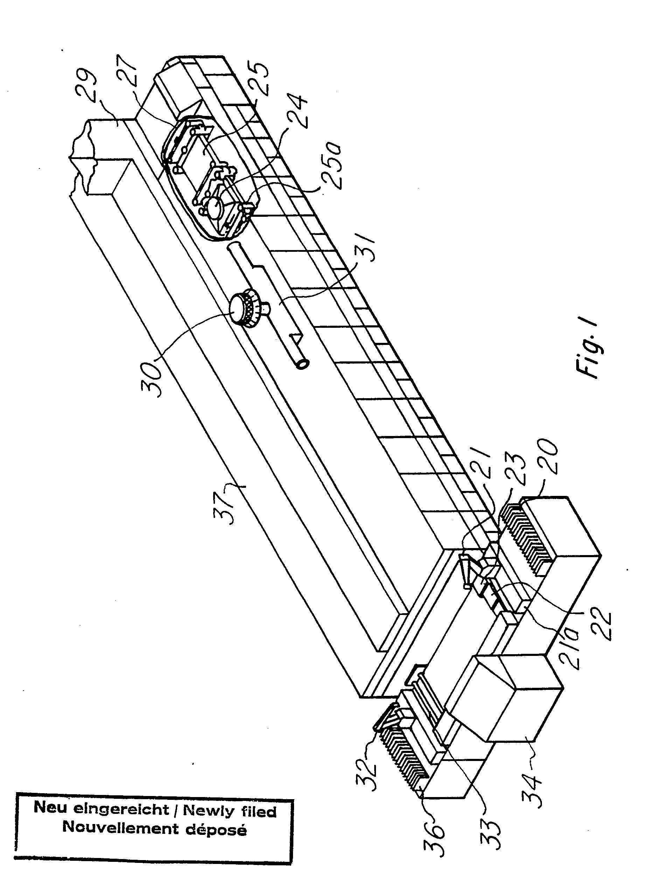

Figure 1 illustrates a typical reactor uitlizing the present invention. A plurality of wafer cassettes 20 are located along and adjacent to a robotic arm 21 which moves along a track 21a. The track allows the robotic arm 21 to move adjacent each of a plurality of wafer cassettes so as to permit the robotic arm to access each wafer in each cassette. The robotic arm lifts a wafer from a cassette and places it in a carrier 22 at the entrance to the reactor. The entrance 23 to the reactor is a seal joint to prevent gases in the reactor from exiting from the reactor.

At the entrance 23, and before the carrier enters the reactor a vacuum pick-up arm (not illustrated) lifts the lid from the carrier to allow the robotic arm to place a semiconductor wafer into the carrier. After the semiconductor is placed into the carrier the carrier lid is replaced and the carrier is indexed through the reactor and the plurality of chambers that make up the reactor.

The carrier is indexed through the reactor and chambers using the length of the carrier and at least one spacer bar between each carrier. As each carrier is indexed into the reactor, each preceding carrier is moved to the next reactor chamber.

The indexing is continuous, and as the carrier exits from the last reaction chamber is moves indexed through the return path of the reactor to the exit opening in the reactor, where the lid of the carrier is removed by the return lid pick-up (not illustrated). Tracks 33, which extend through out the reactor, are used to move the wafer carrier through the reactor. A robotic arm 32 mounded on track 32a removes the semiconductor wafer from the carrier and places it in a wafer cassette 36.

The reactor is divided into a plurality of quartz reactor chambers 25. The reaction chambers 25 are joined by a junction 25a through which is introduced the process gases and from which the used gases are exhausted.

Positioned over each reaction chamber is a heater block 24, used to heat the reaction chamber to a desired temperature. Water to cool the lamp housing is introduced through the junctions 25a through inlet 26.

Each junction 25a has at least one exhaust tube 27 for removing exhaust gases from the reaction chambers. The exhaust gases are directed through a burn-off tube 31 to the gas burner 30.

The entire reactor is shrouded in an enclosure 37, and an air duct 29 is provided to circulate and exhaust gas/air from inside the system shroud.

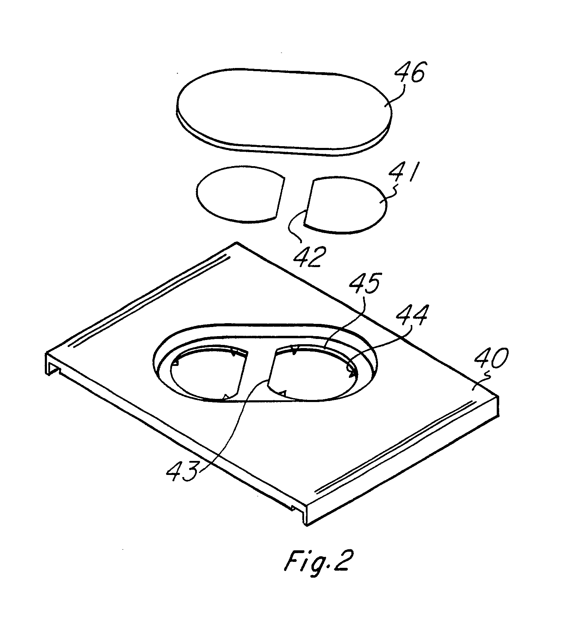

Figure 2 illustrates a typical prior art semiconductor carrier 40 having an opening 45 therein into which is place a semiconductor wafer 45. The wafer has one flat edge 42 which is used to index or orientate the wafer. Opening 45 also has a flat side 43 to match the flat edge 42 of the semiconductor wafer. It is necessary to orientate the wafer such that the flat of the semiconductor wafer matches the flat of the carrier wafer opening. Tabs 44 protrude from the bottom of opening 45 to hold the semiconductor in the opening and to expose a maximum of the under side of the wafer, which is the process side of the wafer.

Lid 46 is used to cover the up, or back, side of the wafer during propcessing, and to distribute heat to the semiconductor wafer during processing.

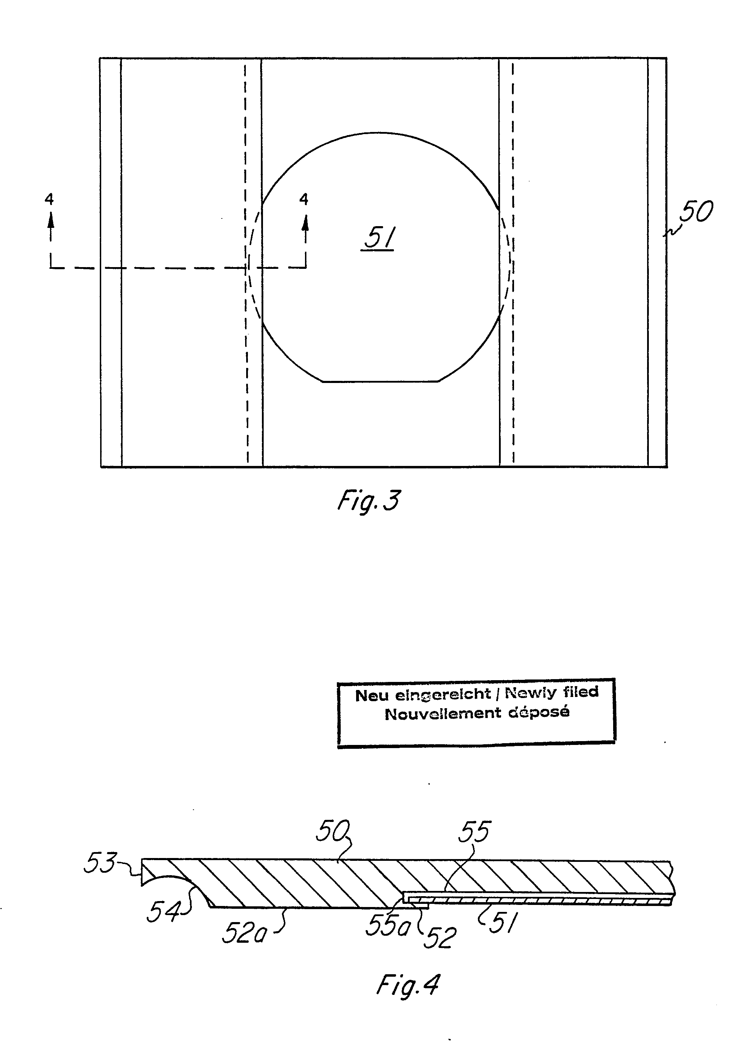

Figure 3 and 4 illustrates the bottom side of a semiconductor wafer carrier 50 with a wafer 51 mounted in recess 55 formed in the bottom of the carrier. The recess 55 has a lip 52 on each side that extends from the side 55a of recess 55 and forms a ledge on which two sides of the semiconductor are supported holding the semiconductor wafer 50 in recess 55. Semiconductor wafer 50 is inserted or loaded into the carrier from the side of the carrier and remains there during processing.

Orientation of the wafer prior to loading is not required. The carrier serves as the susceptor for the wafer and delivers heat to the water.

Two sides of the carrier have ends 53 over a circular groove 52 which slides a long tracks (not illustrated) in the reaction chambers.

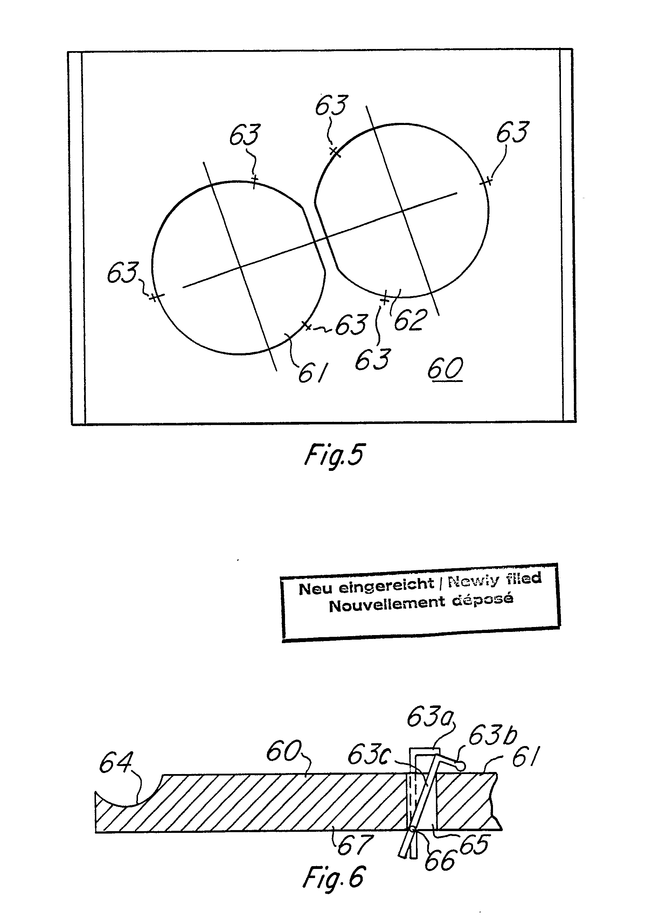

Figures 5 and 6 illustrate another embodiment of a semiconductor wafer carrier. The carrier illustrated has the capacity to hold two semiconductor wafers on the same carrier. The wafers 61 and 62 are held in place by pins 63 located at three points around the wafer.

Each pin 63 is in the form of an inverted "L" with the vertical leg 63c of the "L" extending through an opening 65 in the carrier. The vertical leg 63c is secured by a pin 66 which serves as a fulcrum or pivot point for leg 63c. When there is no wafer on the carrier, or a wafer is being loaded, pin 63 is in the position indicated in Figure 6 at 63a. After a wafer is placed on the carrier, the pin 63 is moved against the wafer such that the horizontal portion of pin 63 is against the wafer and holds wafer 61 in place against the carrier.

In Figure 6, the pin in the holding position is designated 63b. After the wafer is secured to the carrier, the carrier is inverted and placed on tracks extend through the reactor in which the semiconductor wafer is to be processed. The circular grooves 64, there being one on each side of the carrier, engage the tracks (not illustrated) on which the wafer is transported through the reactor.

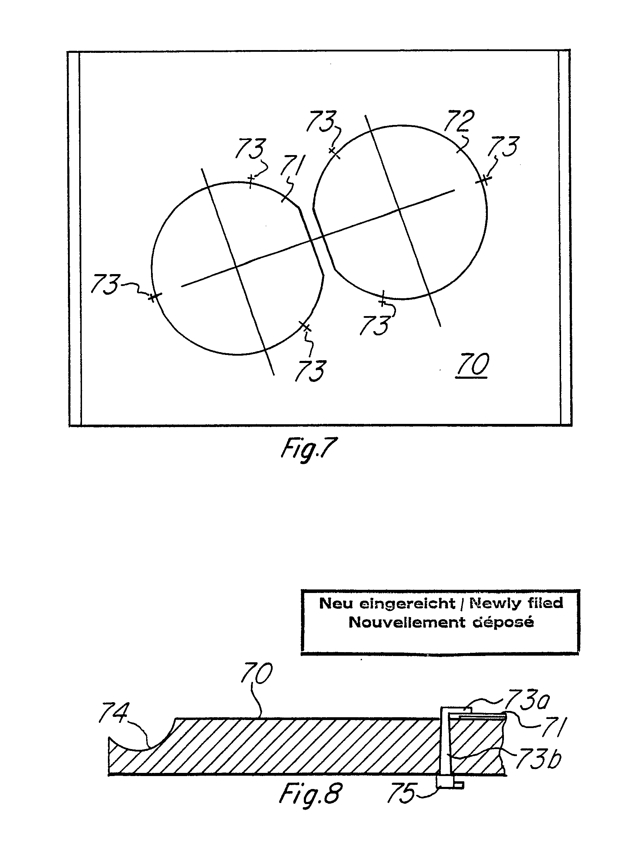

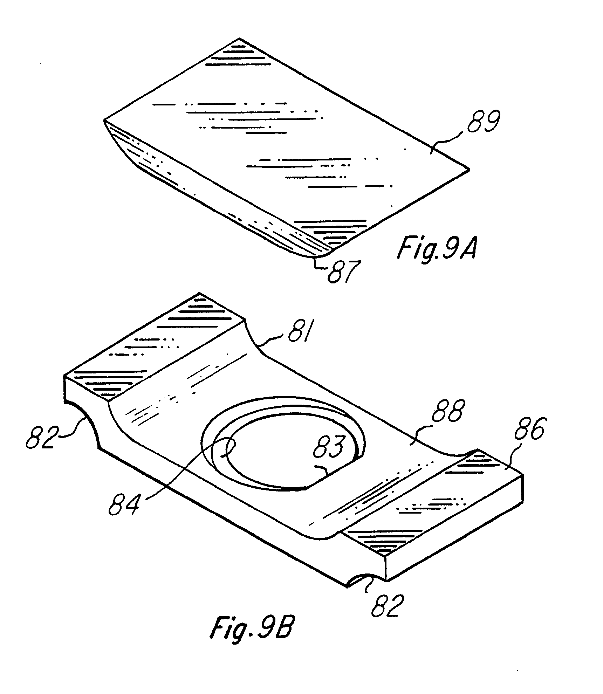

Figures 7 and 8 illustrate a carrier similar to that illustrated in Figures 5 and 6 with different wafer securing pins. Carrier 70 has two wafers 71 and 72 mounted thereon by pins 73. Each pin 73 is in the form of an inverted "L" and extends through the carrier 70. Pin 73 has a vertical part 73b and a horizontal part 73a. the pin rotates such that horizontal part 73a may be turned so that it extends over the semiconductor wafer placed on the surface of the carrier.

There are at least three pins use to secure each semiconductor wafer to the surface of the carrier. After the wafer has been placed on the carrier, the pins are rotated such that the horizontal part 73a extends over the wafer. The carrier may then be inverted and transported through the process reactor on tracts on which grooves 74 reside.

In Figures 5 and 7 the two semiconductor wafers are shown positioned at an angle and do not extend across the length of the carrier. By placing the wafer at an angle, two, for example, six inch wafers may be placed on the carrier, the same sized carrier may be used to hold one eight inch wafer. The design of the carrier permits the processing of either six inch wafers or eight inch wafers in the same reactor system. The diagonal positioning of the wafers also limits the width across the two wafers in the reaction chamber allowing better heat distribution across the wafers.

Through the use of the carrier illustrated in Figures 3 to 8, a lid is not required to be used with the carrier since the carrier, when inverted, protects the backside of the wafer from process gases, and the carrier serves as the heat susceptor for the wafer. The requirement for aligning the wafer such that the flat edge mates with a flat in the carrier has been eliminated.

Figure 9 illustrates an alternative embodiment of the semiconductor carrier and lid of the present invention. Semiconductor carrier 80 has an opening 85 therein into which is place a semiconductor wafer. The wafer has one flat edge which is used to index or orientate the wafer. Opening 85 also has a flat side 83 to match the flat edge of the semiconductor wafer. It is necessary to orientate the wafer such that the flat of the semiconductor wafer matches the flat of the carrier wafer opening.

Semiconductor support area 84 protrudes from the sides of the bottom of opening 85 to hold the semiconductor in the opening and to expose a maximum of the under side of the wafer, which is the process side of the wafer.

Optionally small tabs may extend from the bottom side of opening 85 to support the semiconductor wafer.

The top of carrier 80 has an upper surface 86 and a lower surface 88. The lower surface 48 covers the most of the top surface of carrier 80 and is formed by machining out a portion of the carrier surface to form an opening for lid 86. There is a sloping transition from top surface 86 to lower surface 88 to match the shape of lid 86. Each end of the carrier has as rounded recess 82 which serves as guides to move the carrier along tracks in the reactor (not illustrated).

Lid 86 is used to cover the "up", or back, side of the wafer during processing, and to distribute heat to the semiconductor wafer during processing. The sloping end 87 of the lid matches the sloping transition 81 of the carrier.

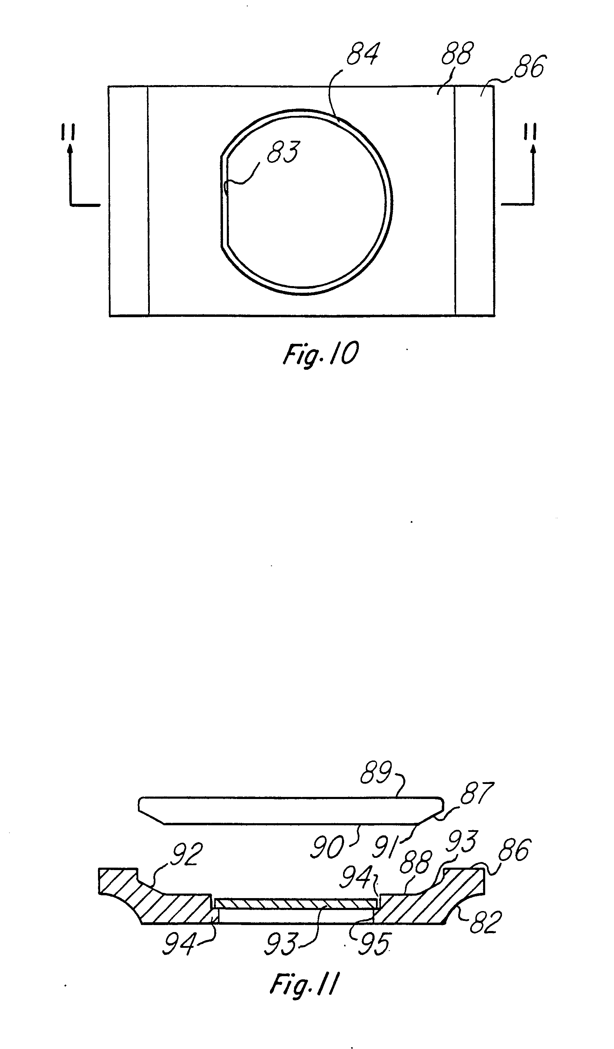

Figure 10 is a top view of carrier 80 showing the top surface 86 and the lower surface 88. The semiconductor support area 84 is recessed in the lower surface area to a depth equal to the thickness of the semiconductor wafer. The flat edge of the semiconductor wafer is positioned in the flat support area 83. the flat has been shown in a particular position, but may be constructed in any desired position in the semiconductor wafer opening.

Figure 11 is a side view of the semiconductor carrier 80 with the lid 89 positioned above it. In Figure 10, a semiconductor wafer 93 is shown positioned on the support area 84.

The lower side (process side) of the semiconductor wafer is exposed through opening 95, allowing the process gases to contact the semiconductor wafer. The depth of the opening 94 into which the semiconductor wafer is placed is greater than the thickness as the semiconductor wafer so that when the lid 49 is placed on the carrier, the lid 89 does not contact the semiconductor and will provide uniform radiant heating from the lid to the semiconductor wafer. Lid 89 rests on surface 88 of the carrier.

Lid 89 has sloping ends 87 to mate with the slopingt surface 96 hich forms the transition between the upper surface 86 and the lower surface 88 of the casrrier. Also the bottom 90 of the lid is rounded at 91 to form a rounded transition between bottom 90 and sloping side 87.

The rounding of the lid opening at the carrier lower surface 88, particularly at 92 is important because square corners tend to cause stress in the carriers and lids due to heating and the resulting expansions of the parts. The large radius at 92 and 91 removes the stresses caused when the carrier and lid are heated to a high temperature during the processing of the semiconductor wafer.

## Claims

1. A semiconductor wafer carrier for use in a continuous chemical vapor deposition reactor, comprising:
a generally rectangular body of a high temperature material having first and second major faces, said first major face having a recess formed in and extending across said first major face,
a generally circular opening extending from the surface of said recess through the carrier and opening through the second of said major face of the carrier,
a lip extending from sides of the generally circular opening for holding a semiconductor wafer, and
a lip shaped to fit in the recess formed in and extending across said first major face to cover a semiconductor wafer residing in said generally circular opening.

2. The carrier according to Claim 1, wherein the lip extending from the sides of the generally circular opening extend from the sides of the opening adjacent said second major face.

3. A semiconductor wafer carrier, having an under side and an upper side, for use in a continuous chemical vapor deposition reactor, comprising:
a generally rectangular body of a high temperature material having two major faces,
an opening through the carrier corresponding to the shape of a semiconductor to be mounted in the carrier;
means for mounting a semiconductor wafer, having a flat orientation edge in said opening through said carrier;
a recess in the upper side of said carrier;
a lip extending from sides of the opening through the carrier for holding a semiconductor wafer; and
a lid having a shape corresponding to the recess in the upper side of said carrier for covering and transmitting heat to said semiconductor wafer.

4. The carrier according to Claim 3, wherein the semiconductor wafer to be mounted on the carrier has a flat orientation edge and the opening through the carrier has a flat edge region to correspond with the flat edge on the semiconductor wafer.

5. The carrier according to Claim 3, wherein the carrier is moved through a reactor on tracts, said carrier having generally circular grooves on two side to mate with and on which to be moved through the reactor.

6. The carrier according to Claim 3, wherein the lid and carrier have rounded corners to prevent stress due to the heating of the lid and carrier during processing of the semiconductor device during processing.

7. A semiconductor wafer carrier, having an under side and an upper side, for use in a continuous chemical vapor deposition reactor, comprising:
a generally rectangular body of a high temperature material having two major faces,
an opening through the carrier corresponding to the shape of a semiconductor to be mounted in the carrier;
means for mounting a semiconductor wafer, having a flat orientation edge in said opening through said carrier;
a recess in the upper side of said carrier;
a lip extending from sides of the opening through the carrier for holding a semiconductor wafer; and
a lid having a shape corresponding to the recess in the upper side of said carrier for covering and transmitting heat to said semiconductor wafer, said lid and carrier have matching tapers to facilitate lid alignment on the carrier.

8. The carrier according to Claim 13, wherein the carrier is moved through a reactor on tracts, said carrier having generally circular grooves on two side to mate with an on which to be moved through the reactor.

9. A semiconductor wafer carrier-susceptor for use in a continuous chemical vapor deposition reactor, comprising a generally rectangular body of a high temperature material having two major faces, one major face having a recess formed in and extending across said one major face, two sides of said recess having lips extending out from the sides of the recess forming two tracks in the sides of the recess such that a semiconductor wafer may be placed in the tracks in the recess and held therein when the carrier-susceptor is positioned with the recess and said one major face in a downward position, said carrier-susceptor also having circular grooves extending across two ends of said one major face.

10. The carrier-susceptor according to Claim 9, wherein the tracks are open at the side of the carrier-susceptor to allow loading of the semiconductor wafer into the side of the carrier-susceptor.

11. A semiconductor wafer carrier-susceptor for use in a continuous chemical vapor deposition reactor, comprising a generally rectangular body of a high temperature material having two major faces, and a plurality of securing pins, said securing pins extending through the carrier-susceptor and comprising a vertical part and a horizontal part, said horizontal part extending above one surface of the carrier-susceptor and used to secure a semiconductor wafer to said one surface of the carrier-susceptor.

12. The carrier-susceptor according to Claim 11, wherein aid securing pins extend through holes in the carrier-susceptor and are movably secured therein by a pivot pin such that the securing pin pivots about the pivot pin allowing the horizontal part of the securing pin to move against and secure a semiconductor wafer on the one surface of the carrier-susceptor.

13. The carrier-susceptor according to Claim 11, wherein there are at least three securing pins spaced around an area larger than the semiconductor wafer to be secured to the carrier-susceptor, each pen is secured so that it will pivot toward the center of the area on which the semiconductor wafer is to be mounted.

14. A semiconductor wafer carrier-susceptor, having an under side and an upper side, for use in a continuous chemical vapor deposition reactor, comprising a generally rectangular body of a high temperature material having two major faces, means for mounting a semiconductor wafer, having a flat orientation edge, on the under side of the carrier-susceptor independent of the orientation of the semiconductor wafer flat edge.

15. The carrier-susceptor according to Claim 14, wherein the semiconductor is mounted in a recess on the under side of the carrier-susceptor.

16. The carrier-susceptor according to Claim 15, wherein the recess has two sides extending to the two edges of the carrier-susceptor and two other sides formed in the underside of the carrier-susceptor, said two other sides two sides of said recess having lips extending out from the sides of the recess forming two tracks that a semiconductor wafer may be placed in the tracks in the recess and held therein.

17. The carrier-susceptor according to Claim 14, wherein said means for mounting a semiconductor wafer to the under side of the carrier-susceptor includes a plurality of securing pins, said securing pins extending through the carrier-susceptor and comprising a vertical part and a horizontal part, said horizontal part extending above one surface of the carrier-susceptor used to secure a semiconductor wafer to said one surface of the carrier-susceptor.

18. A method of mounting two semiconductor wafers on a semiconductor carrier, which carrier is used to mount a semiconductor of a diameter larger than said two semiconductor wafers, comprising the steps of:
placing the two semiconductor wafers diagonally across the carrier: and
securing the semiconductor wafers to the carrier at least three points around the perimeter of the semiconductor wafer.

19. The method according to Claim 18, wherein the semiconductor wafers are placed diagonally across the carrier at an angle between 10 and 15 degrees.

Fig. 1

EP 0 374 740 A2

Fig.2

4 ↑  4 ↑

_51_

_50_

*Fig.3*

50    55

53

54    52a    55a    52    51

*Fig.4*

Fig.5

Neu eingereicht / Newly filed
Nouvellement déposé

Fig.6

73 73 72
73 71
73
73
73
73

*Fig.7*

70

Neu eingereicht / Newly filed
Nouvellement déposé

70
74 73a
71
73b
*Fig.8* 75

Fig.9A

*89*

*87*

Fig.9B

*81*

*82*

*84*

*83*

*88*

*86*

*82*

Fig. 10

Fig. 11